# EUROPEAN PATENT SPECIFICATION

(11) **EP 1 584 705 B1**
(45) Date of publication and mention of the grant of the patent: **25.06.2008**
(21) Application number: 05004709.1
(22) Date of filing: 03.03.2005
(51) Int. Cl.: C23C 14/24, C23C 14/54

(54) **Vapor source for film formation apparatus**
Dampfquelle für Beschichtungsanlage
Source de vapeur pour dispositif de revêtement.

(30) Priority: 30.03.2004 JP 2004099944
(43) Date of publication of application: 12.10.2005
(73) Proprietor: Tohoku Pioneer Corporation, Tendo-shi, Yamagata-ken (JP)
(72) Inventor: Abiko, Hirosi Yonezawa Koujou, Yonezawa-shi Yamagata-ken 992-1128 (JP); Masuda, Daisuke Yonezawa Koujou, Yonezawa-shi Yamagata-ken 992-1128 (JP); Umetsu, Shigehiro Yonezawa Koujou, Yonezawa-shi Yamagata-ken 992-1128 (JP)
(74) Representative: Popp, Eugen

(56) References cited:
- EP-A- 1 357 200
- US-A- 3 690 933
- US-A- 5 589 110
- US-A- 5 674 563
- PATENT ABSTRACTS OF JAPAN vol. 2003, no. 12, 5 December 2003 (2003-12-05) -& JP 2004 043853 A (SONY CORP), 12 February 2004 (2004-02-12)
- PATENT ABSTRACTS OF JAPAN vol. 2003, no. 12, 5 December 2003 (2003-12-05) & JP 2003 257635 A (ULVAC JAPAN LTD), 12 September 2003 (2003-09-12)
- PATENT ABSTRACTS OF JAPAN vol. 017, no. 162 (C-1042), 30 March 1993 (1993-03-30) & JP 04 323362 A (ULVAC JAPAN LTD), 12 November 1992 (1992-11-12)

## Description

### BACKGROUND OF THE INVENTION

The present invention relates to a film formation source, a film formation apparatus, a film formation method, an organic EL panel, and a method of manufacturing the organic EL panel.

A film formationapparatus for forming a filmof a solidmaterial on a substrate is usually equipped with a film formation source containing a film formation material and located within a film formation chamber kept at a vacuum or depressurized state. Such a film formation apparatus may be a vacuum vapor deposition apparatus which heats a vapor deposition source positioned within a vacuum chamber, so that a depositionmaterial discharged from an evaporation outlet of the vapor deposition source can be formed into a film on a substrate disposed within the vacuum chamber.

In view of the structure of such film formation apparatus or film formation source, it is understood that the vacuum condition within the vacuum chamber has to be broken each time a film formation material is supplemented to the film formation source. As a result, considerable time is needed for returning the internal atmosphere of the chamber to a desired condition when restarting the film formation, hence making it impossible to carry out the film formation with a high efficiency.

On the other hand, an organic EL panel manufacturing method which has drawn considerable attentions in the field of display or illumination, includes a step of forming a first electrode on a substrate, a step of forming thereon an organic material layer consisting of organic compounds, followed by forming thereon a second electrode. When forming an organic material layer or electrode layers, it is usual to carry out film formation steps using the above-described film formation apparatus. As a result, if a mass-production of such organic EL panel is to be carried out, the foregoing problem which occurs when supplementing film formation material becomes remarkable, rendering it impossible to ensure an acceptable productivity.

Moreover, each organic EL device serving as an essential element for an organic EL panel contains an organic material layer formed by a plurality of films having different functions. Further, an organic EL panel for multi-color displaying is formed in such a manner that organic EL devices consisting of different luminescent materials are formed on a substrate, so that it is necessary to perform film formation of different materials on a single substrate. However, since the above-described film formation apparatus or film formation source have been found difficult to carry out film formation of different materials in one chamber, it is necessary to employ a plurality of chambers, hence resulting in an enlarged scale of film formation apparatus and a complex manufacturing process.

In order to solve the problem mentioned above, Japanese Unexamined Patent Application Publication No. 2003-317957 has disclosed an improved vapor deposition apparatus in which one or more detachable vapor deposition sources are disposed outside a film formation chamber, a steam distributor having evaporation outlets is disposed within the chamber, a steam transporting system including valves is connected between each vapor deposition source and the steam distributor.

According to the above patent publication, when film formation material is supplied to the vapor deposition source or the deposition source is exchanged, it is not necessary to break the vacuum state within the chamber, so that it is allowed to shorten an operation time. Meanwhile, if the vapor deposition is switched over so that different material can be deposited, it is possible to perform film formations of different materials in single one chamber.

However, when the above-mentioned art is adopted, some problems which will be discussed below make it difficult to improve the workability and the operational precision of film formation process, the productivity and yield of an organic EL panel manufacturing process.

Namely, with regard to a film formation source in which a film formation material is sublimated or evaporated by heating, it is difficult for the film formation material to be discharged at a desired state even if heating is started, hence requiring a relatively long operation time until a desired discharge state is obtained. Moreover, even when heating has been stopped, it is still difficult to stop the discharge of the film formation material at once, hence requiring a relatively long time until the discharge gradually stops. In addition, when a film formation material contained in a film formation source has decreased, the discharge rate of the film formation material will also drop, hence rendering it impossible to ensure a desired discharge state. Besides, even if heating is carried out to control the discharge state of the film formation material, a relatively long operation time is required until a heated material is sublimated or evaporated so as to be discharged (as described above) . As a result, a control system will become a system involving a large time constant, hence rendering it difficult to effectively control the discharge state of the film formation material only by controlling the heating.

In order to solve the above problem, the aforementioned prior art provides valve in material transport system for transporting the film formation material, thereby adjusting the discharge state by adjusting an opening degree of the valve. However, when the valve is provided in an airtight transport system which directs a film formation material (which is produced from a film formation source located outside the film formation chamber) to a discharge outlet of the film formation chamber, since the sublimation or evaporation of the film formation material is difficult to be decelerated at once even if the opening degree of valve is narrowed and a heating velocity is reduced, a reduction in the opening degree of the valve can increase an internal pressure of the film formation chamber. As a result, the material contained in the film formation source will be undesirably modified due to its decomposition or the like, rendering it impossible to effect an acceptable film formation. Besides, an operation pressure will go beyond a controllable range, making it impossible to perform an acceptable discharge rate control. Namely, in the above-described prior art, when valve is used to control the discharge state of the film formation material, the film formation material contained within the film formation source will get deteriorated in its quality, an operation pressure will go beyond a controllable pressure range, hence rendering it impossible to perform an acceptable film formation.

Moreover, in response to an actual condition of film formation, it might be necessary to quickly shut off the film formation material flowing from the film formation source to a substrate. At this time, if merely the above-mentioned valve is closed, there will be an increase in an internal pressure of the film formation chamber and this can cause an undesired modification in the film formation material contained in the film formation source, and cause an operation pressure to go beyond a controllable range. As a result, it is impossible to carry out an acceptable film formation by using such a film formation source.

In order to avoid the above problem, it is possible to interpose a shielding member (shutter) between the discharge outlet and an object on which a film is formed. However, if this is realized, a considerable amount of film formation material will adhere to the shielding member, making it impossible to smoothly restart film formation and difficult to recover the adhered material. Besides, since the film formation material forming an organic material layer for an organic EL panel is expensive, an effort for increasing the recovery rate of a film formation material not used in the film formation process is extremely important for reducing the production cost.

On the other hand, according to the above-described prior art, before the film formation source disposed outside the film formation chamber is exchanged without using a valve to shut off the transport system, the film formation material is usually continued to be discharged until the material is used up, and the film formation source is then replaced by a new film formation source at the time the material has become zero. However, since it is impossible to ensure a desired discharge state and the film formation process has to be stopped temporally before and after the exchange of the film formation source, it is impossible to continuously perform the film formation operation while at the same time maintaining a desired film formation state (even if it is possible to exchange the film formation source) for a long time.

When a conventional film formation apparatus or a conventional film formation source having the above-described problem is used to manufacture an organic EL panel, since it is impossible to continuously maintain a desired film formation state for a long time, it is difficult to greatly improve the productivity of panel manufacturing process. Moreover, if such a conventional art is adopted to carry out a prolonged film formation operation, it is impossible to maintain an acceptable discharge state of film formation material, hence rendering it difficult to produce a high quality organic EL panel.

### SUMMARY OF THE INVENTION

The present invention is to solve the above-discussed problem, and it is an object of the invention to perform a film formation process capable of producing an acceptable film, avoiding a deterioration of a film formation material when supplementing or exchanging the same, controlling the discharge state of the film formation material, improving the productivity of an organic EL panel manufacturing process, and improving product yield by improving film formation precision.

In order to achieve the above objects, the present invention is characterized by at least the following aspects.

According to one aspect of the present invention, there is provided a film formation apparatus having a film formation chamber in which a vacuum or a depressurized state is formed and a sublimated or evaporated film formation material is formed into a film on a substrate, such film formation apparatus comprising: a discharge outlet disposed within the film formation chamber for discharging the film formation material towards a film formation surface of the substrate; a material accommodating section disposed outside the film formation chamber and including a material container containing the film formation material; a heating device for heating the film formation material contained in the material container; a discharge passage air-tightly communicating the discharge outlet with the material accommodating section; an escape passage branching from the discharge passage for diverting the film formation material moving towards the discharge outlet to a different direction; and flow restricting devices provided at least on the lower stream side of a branching position of the discharge passage and on the escape passage, for stopping/passing or variably adjusting the flow of the film formation material.

According to another aspect of the present invention, there is provided a film formation method in which a discharge outlet is caused to face a film formation surface of a substrate disposed within a film formation chamber kept at a vacuum or depressurized state, a film formation material sublimated or evaporated by heating in a material accommodating section disposed outside the film formation chamber is allowed to flow through a discharge passage and discharged from the discharge outlet so as to form a film on the film formation surface. In particular, an escape passage is provided by branching from the discharge passage for diverting the film formation material moving towards the discharge outlet to a different direction. Further, a flow through the escape passage is started when the flow of the film formation material is shut off or restricted on the lower stream side of a branching position of the discharge passage.

### BRIEF DESCRIPTION OF THE DRAWINGS

These and other objects and advantages of the present invention will become clear from the following description with reference to the accompanying drawings, wherein:
Fig. 1 is an explanatory view showing the basic structure of a film formation source and a film formation apparatus employing the film formation source, according to one embodiment of the present invention;
Fig. 2 is another explanatory view showing a film formation source and a film formation apparatus employing the film formation source, according to another embodiment of the present invention shown in more detail than the above embodiment;
Fig. 3 is a further explanatory view showing a film formation source and a film formation apparatus employing the film formation source, according to a further embodiment of the present invention; and
Fig. 4 is an explanatory view showing an example of an organic EL panel manufactured in the apparatus and method of the present invention.

### DETAILED DESCRIPTION OF THE PREFERRED EMBODIMENTS

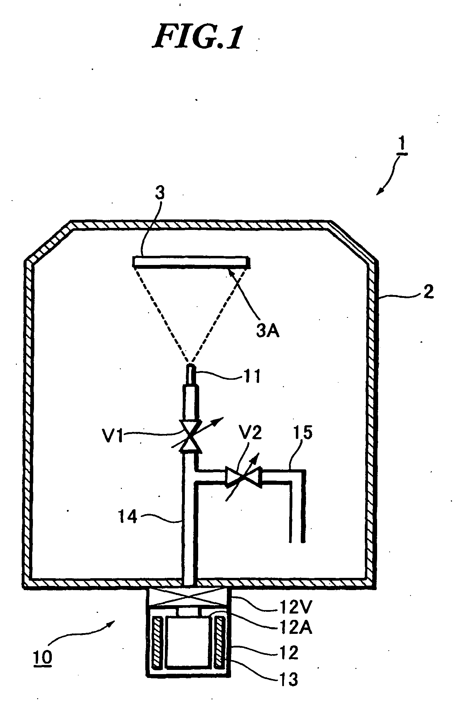

Preferred embodiments of the present invention will be described below with reference to the accompanying drawings. Fig. 1 is an explanatory view showing a film formation source and the fundamental structure of a film formation apparatus containing the film formation source, according to one embodiment of the present invention. As shown, a film formation apparatus 1 comprises a film formation chamber 2 and a film formation source 10. In the film formation chamber 2 kept at a vacuum or depressurized state, a film formation material is sublimated or evaporated and formed into a film on a film formation surface 3A of a substrate 3.

The film formation source 10 comprises: a discharge outlet 11 disposed within the film formation chamber 2 for discharging the film formation material onto the film formation surface 3A of the substrate 3; a material accommodating section 12 disposed outside the film formation chamber 2 and having a material container 12A accommodating the film formation material; a heating device 13 (heating means) for heating the film formation material contained within the material container 12A; a discharge passage 14 which is air-tightly communicated with the discharge outlet 11 as well as with the material accommodating section 12; an escape passage 15 branching from the discharge passage 14 for diverting the film formation material flowing towards the discharge outlet 11. On the downstream side of the branching position of the discharge passage 14 as well as on the escape passage 15, there are provided flow restricting valves V1, V2 (means for restricting the flow of film formationmaterial) capable of stopping or passing the film formation material or variably adjusting the flow of the film formation material.

The material accommodating section 12 is in an air-tight condition andprovidedwith a gate valve 12V on the upper side thereof, with the material container 12A air-tightly connected to the discharge passage 14 using a metal gasket. Then, if the material container 12A is disconnected from the discharge passage 14 and the gate valve 12V is closed, it is allowed to open the material accommodating section 12 to the surrounding atmosphere to remove or exchange the material container 12A, without bringing about any change in the atmosphere within the film formation chamber 2. Moreover, the material accommodating section 12 can also be provided with an additional mechanism for vertically moving the material container 12A in order to connect or disconnect the same to or from the discharge passage 14. Further, although not shown in the accompanying drawings, the material accommodating section 12 and the material container 12A can be exhausted independently of the film formation chamber 2. Moreover, similar to the above-discussed prior art (Japanese Unexamined Patent Application Publication No. 2003-317957), it is allowed to employ an adjusting valve instead of the gate valve.

In the film formation method utilizing the film formation apparatus 1, film formation operation is performed by completely opening the flow restricting valve V1 to open the discharge passage 14 and by closing the flow restricting valve V2 to shut the escape passage 15, so that the film formation material sublimated or evaporated by heating in the material accommodating section 12 disposed outside the film formation chamber 2, will flow through the discharge passage 14 and be discharged from the discharge outlet 11 to the film formation surface 3A, thus forming a desired film on one surface of the substrate 3. Further, if the flow through the discharge passage 14 is to be shut off or reduced by closing or narrowing the flow restricting valve V1, it is allowed to open the flow restricting valve V2 so as to start flowing through the escape passage 15.

In this way, by optionally adjusting the opening degree of the flow restricting valve V1, it is possible to freely adjust the discharge state (for example, vapor deposition rate) of the film formation material from the discharge outlet 11. At this time, by properly opening the flow restricting valve V2 on the escape passage 15 in response to the opening degree of the flow restricting valve V1, the film formation material throttled by the flow restricting valve V1 can escape to the escape passage 15. Therefore, it is possible to prevent the pressure within the material container 12A of the film formation source 10 from rising up, thus avoiding a deterioration of the film formation material within the material container 12A and preventing the film formationmaterial from leaving a desired pressure range. Accordingly, even when the discharge state of the film formation material (for example, flow rate) has been changed (controlled), it is still possible to ensure a high quality film formation, without causing a deterioration of the film formation material and its departure from a desired flow rate range.

At the beginning of a heating process using the heating device 13, although it takes a certain time to reach a desired discharge state, the flow restricting valve V1 is closed to shut the discharge passage 14 while the flow restricting valve V2 is opened to open the escape passage 15, such a condition being continued until the discharge state from the material accommodating section 12 reaches a predetermined one. After the discharge from the material accommodating section 12 has reached a predetermined state, the flow restricting valve V1 is opened to open the discharge passage 14 while the flow restricting valve V2 is closed to shut the escape passage 15, so that film formation can be started and the discharge is controlled at a desired state, thereby ensuring a desired film formation from the beginning of the film formation process.

On the other hand, once the film formation material within the material container 12A decreases, it will become impossible to ensure a desired discharge state. At this time, if the flow restricting valve V1 is closed to shut the discharge passage 14 while the flow restricting valve V2 is opened to open the escape-passage 15, it is possible to stop the discharge from the discharge outlet 11 before the discharge state gets worse, and to avoid a possible deterioration of the film formation material which is usually caused by a pressure change.

Although an example illustrated herein shows that the flow restricting valves V1, V2 and the escape passage 15 are provided within the film formation chamber 2, the present invention should not be limited by such a specific example. Infact, it is also possible for the flow restricting valves V1, V2 and the escape passage 15 to be disposed outside the film formation chamber 2. At this time, the front end of the escape passage 15 should of course be held within a vacuum container other than the film formation chamber 2.

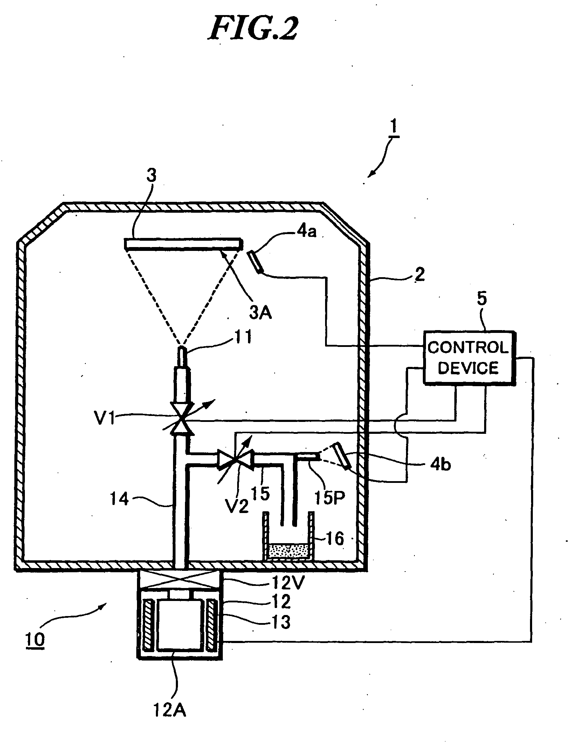

Fig. 2 is an explanatory view showing a film formation source and a film formation apparatus containing the film formation source, according to another embodiment of the present invention which is a more detailed example based on the above-described embodiment (elements which are the same as those described above will be represented by the same reference numerals and the related descriptions will be partially omitted).

Actually, this embodiment is characterized by a film formation material collection device 16 provided at the end of the escape passage 15. Namely, according to the film formation method using the film formation source 10 of the film formation apparatus 1 of the present embodiment, the film formation material collection device 16 is provided at the end of the escape passage 15, so that it is possible to collect the film formation material passing through the escape passage 15. In this way, since the film formationmaterial collection device 16 can collect the film formation material passing through the escape passage 15, it is allowed to omit an additional step for recovering the unused material, thereby making it possible to effectively reuse the film formation material and thus improving the economical efficiency of the film formation process.

Although an example illustrated herein shows that the film formation material collection device 16 is installed within the film formation chamber 2, the present invention should not be limited by this. Actually, it is also possible to extend the escape passage 15 so that its front end is disposed on the outside of the film formation chamber 2 and the film formationmaterial collection device 16 is allowed to be connected with the escape passage 15 outside the film formation chamber 2. In this way, it is possible to reuse the film formation material collected by the film formation material collection device 16 without breaking the vacuum state of the film formation chamber 2. Also, since it is possible to exchange the film formation material collection device 16 (filled with the film formation material) without breaking the vacuum state of the film formation chamber 2, it is allowed to improve the efficiency of the film formation process, thereby ensuring a smooth and continuous film formation operation.

Moreover,the present embodimentischaracterized by providing, on one or each of the discharge passage 14 and the escape passage 15, a detection port 15P for detecting the flowing state of the film formation material, and detectors 4a, 4b (detection device, thickness monitoring device or the like) for detecting the film formation material in the vicinity of the substrate 3 or discharged from the detection port 15P. Furthermore, the film formation apparatus 1 has a control unit 5 (control device) for controlling the valves V1, V2 in accordance with the detection results of the detectors 4a, 4b. In addition, it is also possible for the control unit 5 to control the heating device 13 of the material accommodating section 12. Preferably, the control unit 5 can control both of the valves V1 and V2, as well as the heating device 13.

In this way, by using the detector 4a to detect the film formation material discharged from the discharge passage 14 and by controlling the opening degrees of the valves V1, V2 in accordance with the detection results, it is possible to freely control the discharge state (for example, vapor deposition rate) from the discharge outlet 11, without decomposing the film formation material contained in the film formation source 10, nor causing an increased pressure higher than a predetermined range. For example, if it is detected that the discharge state from the discharge outlet 11 is at a high rate, the flow restricting valve V1 is closed to some extent, whereas the flow restricting valve V2 is opened, thereby inhibiting the high rate discharge state so as to obtain a uniform discharge rate, and controlling the inner pressure of the film formation source 10 within a desired pressure range which ensures an acceptable film formation.

Moreover, by using the detector 4b to detect the film formation material discharged from the detection port 15P (located on the downstream side of the flow restricting valve V2 of the escape passage 15), and by opening or closing the valves V1, V2 in accordance with the detection results, it is possible to perform a control to change one state (wherein the flow restricting valve V1 is closed and the flow restricting valve V2 is opened) to another (wherein the flow restricting valve V1 is opened and the flow restricting valve V2 is closed), in response to the discharge state (such as a standup state at the beginning of a heating process) from the material accommodating section 12.

Moreover, if the discharge from the discharge outlet 11 is to be stopped immediately as an urgent measure, the control unit 5 will operate to open the flow restricting valve V2 and at the same time close the flow restricting valve V1. At this time, if the heating device 13 is maintained at its operative state and if the valve V1 is opened and the valve V2 is closed, it is possible for the apparatus to quickly return back to its previous operation state existing before the stopping. On the other hand, if the apparatus does not require any urgent restoration for returning back, it is allowed to close the valve V1 and open the valve V2, as well as to stop the operation of the heating device 13.

In this way, since it is not necessary to employ any blocking member such as shutter during an urgent shut-off, it is possible to ensure a smooth operation for returning back. Meanwhile, since there would be no film formation material to adhere to a blocking member such as shutter, it is possible to ensure an easy recovery of the film formation material and thus an economical film formation process.

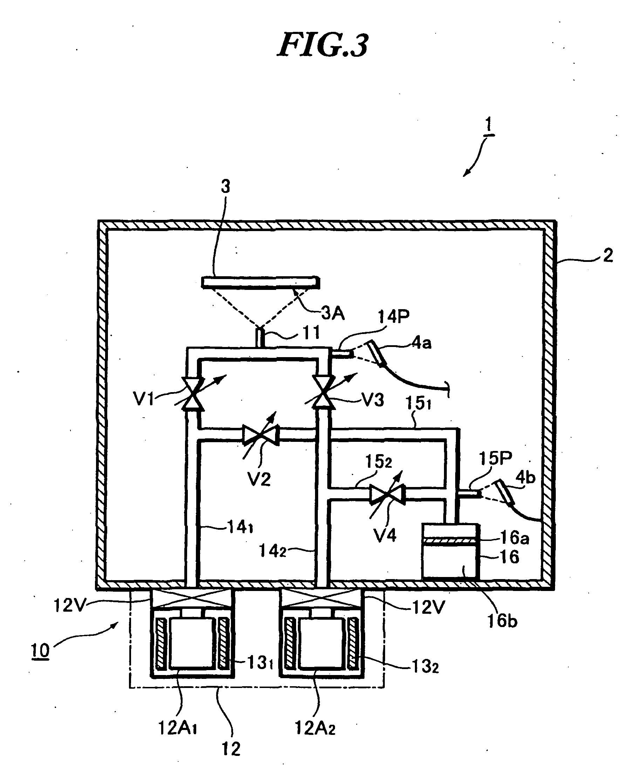

Fig. 3 is an explanatory view showing a film formation source formed according to another embodiment of the present invention and a film formation apparatus containing the film formation source (elements which are the same as those in the foregoing embodiment will be represented by the same reference numerals and the description thereof will be partially omitted).

In the present embodiment, the material accommodating section 12 has detachable or exchangeable material containers 12A₁ and 12A₂ which are connected with discharge passages 14₁ and 14₂ communicated with their common discharge outlet 11.

As shown, the first material container 12A₁ of the material accommodating section 12 disposed outside the film formation chamber 2 is connected with the discharge passage 14₁ and communicated with the discharge outlet 11 through the discharge passage 14₁, while the second material container 12A₂ is connected with the discharge passage 14₂ and communicated with the discharge outlet 11 through the discharge passage 14₂.

Further, escape passages 15₁, 15₂ are branching from the discharge passages 14₁, 14₂ and are connected through their end portions to film formation material collection device 16. Although an example illustrated herein shows that the escape passages 15₁, 15₂ are communicated with each other at their end portions and connected to the film formation material collection device 16, it is also possible to provide one film formation material collection device 16 at the end of each of the escape passages 15₁, 15₂. Moreover, in case where the material containers 12A₁ and 12A₂ are used to hold different materials, it is necessary for each of the escape passages 15₁, 15₂ to have its own film formation material collection device 16. Moreover, although an example illustrated herein shows that the film formation material collection device 16 is installed within the film formation chamber 2, it is also possible to extend the escape passages 15₁, 15₂ so that their end portions are disposed on the outside of the film formation chamber 2, thereby allowing the film formation material collection device 16 to be installed outside the film formation chamber 2.

Further, similar to the foregoing embodiment, the flow restricting valves V1 and V2 are provided on the discharge passage 14₁ of the first material container 12A₁ and on the escape passage 15₁, while the flow restricting valves V3 and V4 are provided on the discharge passage 14₂ of the second material container 12A₂ and on the escape passages 15₂.

Moreover, the material accommodating section 12 contains heating devices 13₁ and 13₂ located within the first material container 12A₁ and the second material container 12A₂. Further, a heat-insulator 16a is provided in the film formation material collection device 16, while a cooling unit 16b is formed beneath the heat-insulator 16a. Besides, although an example illustrated herein involves two material containers 12A₁ and 12A₂, it is also possible to include three or more material containers which have similar structures.

By using the film formation source 10, the film formation apparatus 1 containing the film formation source 10, and the method employing the film formation apparatus 1, it is possible for each of the discharge passages 14₁, 14₂ of the material containers 12A₁, 12A₂ as well as the escape passages 15₁, 15₂ to obtain the same effect as obtained in the foregoing embodiment. As compared with the foregoing embodiment, the present embodiment is suitable for carrying out continuous film formation during a prolonged time.

Namely, according to the present embodiment, film formation material within the first material container 12A₁ is heated by the heading device 13₁ so as to be discharged from the first material container 12A₁. At this time, similar to the foregoing embodiment, the flow restricting valve V1 is closed and the flow restricting valve V2 is opened, so that it is allowed to perform a pre-heating until the discharge from the first material container 12A₁ reaches a desired state. After the discharge from the first material container 12A₁ has reached a desired state, the flow restricting valve V1 is opened and the flow restricting valve V2 is closed, so as to discharge the film formationmaterial from the first material container 12A₁ through the discharge outlet 11, thereby effecting the film formation on the film formation surface 3A of the substrate 3.

In this way, a plurality of substrates 3 are allowed to be successively moved into the film formation chamber 2 so as to effect a continuous film formation. In this manner, the film formation material within the material container 12A₁ will decrease and this makes it difficult to maintain the material discharge at a predetermined state. In order to maintain the material discharge at a predetermined state, pre-heating is started to heat the film formation material within the second material container 12A₂. Namely, prior to shutting the discharge passage 14₁ of the first material container 12A₁, heating is started to heat the film formation material in the second material container 12A₂ until the discharge from the second material container 12A₂ reaches a predetermined state. At this time, the flow restricting valve V3 is closed to shut the discharge passage 14₂ of the second material container 12A₂, while the flow restricting valve V4 is opened to open the escape-passage 15₂. Then, after the discharge from the second material container 12A₂ has reached a predetermined state, the flow restricting valve V3 is opened to open the discharge passage 14₂, while the flow-restricting valve V4 is closed to shut the escape-passage 15₂.

Accordingly, prior to exchanging the first material container 12A₁ it is allowed to pre-heat the second material container 12A₂, so that when the discharge from the first material container 12A₁ is stopped, the film formation material can be discharged from the second material container 12A₂, thereby immediately enabling the film formation material to be discharged through the outlet 11 in a desired state. Preferably, the discharge changeover is performed during a period in which the discharge outlet 11 does not directly face the film formation surface 3A of the substrate 3. In other words, the discharge changeover is preferred to be performed after a treated substrate has been moved away and before an untreated substrate is moved into the film formation chamber 2. Alternatively, the discharge changeover is carried out with a shielding plate (such as shutter) interposed between the film formation surface 3A and the discharge outlet 11.

Moreover, during the discharge changeover from the material container 12A₁ to the material container 12A₂, it is possible to perform an appropriate control of the flow restricting valves V1-V4 in accordance with the detection results of detectors 4a and 4b. At this time, the flow restricting valves V1-V4 can be controlled at the states shown in the following Table 1.

**Table 1**

| | V1 | V2 | V3 | V4 |
|---|---|---|---|---|
| STATE 1 | OPEN | CLOSED | CLOSED | CLOSED |
| STATE 2 | OPEN | CLOSED | CLOSED | OPEN |
| STATE 3 | OPEN | CLOSED | GRADUALLY OPENED | OPEN |
| STATE 4 | GRADUALLY CLOSED | GRADUALLY OPENED | PARTIALLY OPENED | GRADUALLY CLOSED |
| STATE 5 | CLOSED | OPEN | OPEN | CLOSED |
| STATE 6 | CLOSED | CLOSED | OPEN | CLOSED |

Therefore, it is possible for the material discharge from the discharge outlet 11 to be controlled within a minimum time period required only for the opening or closing of the valves, thereby ensuring a smooth changeover from the discharge out of the first material container 12A₁ to the discharge out of the second material container 12A₂. Further, even when the discharge out of the first material container 12A₁ has been changed over to the discharge out of the second material container 12A₂, there would be no deviation in the position of the discharge outlet 11 since the discharge outlet 11 is common to discharges from both the first material container 12A₁ and the second material container 12A₂, thus allowing the substrate 3 and the detector 4a to be fixed in their original positions.

If, after opening the discharge passage 14₂ of the second material container 12A₂, the discharge passage 14₁ of the first material container 12A₁ is to be closed, since at this time the discharge from the first material container 12A₁ does not stop immediately even if the heating of the first material container 12A₁ is stopped, the discharge passage 14₁ shall be closed and the escape-passage 15₁ shall be opened, thereby allowing the film formation material collection device 16 to collect the remaining film formation material. Then, after the discharge from the first material container 12A₁ has been accumulated to some extent, the gate-valve 12V in connection with the first material container 12A₁ is closed, so that the first material container 12A may be removed to supplement the film formation material therein or replaced by a new material container. Subsequently, since it is allowed to perform similar changeover from the second material container 12A₂ to the first material container 12A₁, a repeated operation makes it possible to perform continuous film formation under the same condition for a long time.

Moreover, if the present embodiment is further improved by controlling the discharge state in accordance with the detection result of the detector 4a described in the embodiment of Fig. 2, it is possible to perform a high precision film formation for a long time period. In addition, if valve changeover is controlled in accordance with the detection result of the detector 4b, it is possible to realize a continuous film formation for a long time by performing an automatic changeover.

Moreover, in the present embodiment, the film formation material contained in the first material container 12A₁ is the same as the film formation material contained in the second material container 12A₂, so that it is possible to perform a continuous film formation for a long time period, as described above. However, if the film formation material contained in the first material container 12A₁ is different from the film formation material contained in the second material container 12A₂, it is possible to effect a smooth changeover from one film formation based on one film formation material to another film formation based on another film formation material, by virtue of the same effect as described above.

Here, each of the flow restricting valves V1-V4 mentioned above can be formed by an independently variable adjusting valve. However, if it is difficult to ensure an adequate durability as well as an adequate reliability during full closure of valve, it is allowed to form a combination of ON-OFF valves (capable of effecting a changeover between closing and opening) with variable adjusting valves. Moreover, although not shown in the accompanying drawings, it is also possible to employ a three-way valve or a combination of the three-way valve with valves V1 and V2. Besides, as to the flow restricting valves V2, V4 provided on the escape passages 15,15₁,15₂, it is allowed to use only ON-OFF valves capable of effecting a changeover between closing and opening (but not having variable adjusting function). In addition, the flow restricting valves V1-V4 are not absolutely necessary to be valves, but can be replaced by other flow restricting device such as shutters.

Moreover, if necessary, it is also possible to provide heating device in one of other positions not included in the material accommodating section 12, such as the discharge passages 14, 14₁, 14₂, the escape passages 15,15₁,15₂, the discharge outlet 11, and the detection ports 14P, 15P. In this way, it is possible to ensure smoother flowing or discharge of the film formation material from the material accommodating section 12.

Further, the film formation apparatus 1 mentioned above may be a vacuum deposition apparatus using a resistance heating method, a high-frequency heating method, a laser heating method, or an electron beam heating method. However, a method for use in the vacuum deposition apparatus 1 should not be limited as such. For example, if the vacuum deposition apparatus employs a resistance heating method, the film formation chamber 2 may be a vacuum chamber set at a high vacuum condition (10⁻⁴ Pa or less), while the material accommodating section 12 may be a container formed by a high-melting point oxide such as alumina (Al₂O₃) and Beryllia (BeO), and surrounded by a heating device 13 consisting of high melting point filament such as tantalum (Ta), molybdenum (Mo), and tungsten (W), or consisting of a boat-like heating coil. Besides, the film formation may be a discontinuous process in which substrates are treated individually or an inline type process inwhich substrates are treated continuously.

Besides, although an example illustrated herein shows that the discharge outlet 11 is arranged to face upward and the film formation surface 3A is arranged to face downward, the present invention shouldnot be limitedby such a specific example. Actually, it is also possible for the discharge outlet 11 to face in the horizontal direction and the substrate 3 in an upright direction so that its film formation surface 3A can face the discharge outlet 11. Here, the discharge outlet can have any desired shape which may be circular or rectangular, and it is also possible to employ a plurality of such discharge outlets in order to continuously effect a uniform film formation on the film formation surface 3A.

The above-described film formation apparatus 1 and the film formation method using the film formation apparatus 1 are suitable for manufacturing an organic EL panel. Such an organic EL panel includes a substrate and organic EL devices formed on the substrate, each organic EL device has a pair of electrodes including a first electrode and a second electrode, an organic layer interposed between the pair of electrodes, such an organic layer contains an organic luminescent layer. When at least one sort of film formation material for forming the electrodes or the organic material layer is formed into a filmon the substrate 3, it is allowed to use the above-described film formation apparatus 1 and the film formation method using the film formation apparatus 1. In this way, since it is possible to effect a high precision film formation (for a long time period) on the film formation surface 3Aof each substrate 3 being successively moved into the film formation chamber 2, it is possible to improve the productivity of an organic EL panel manufacturing process, thus improving the yield of production by improving the precision of film formation.

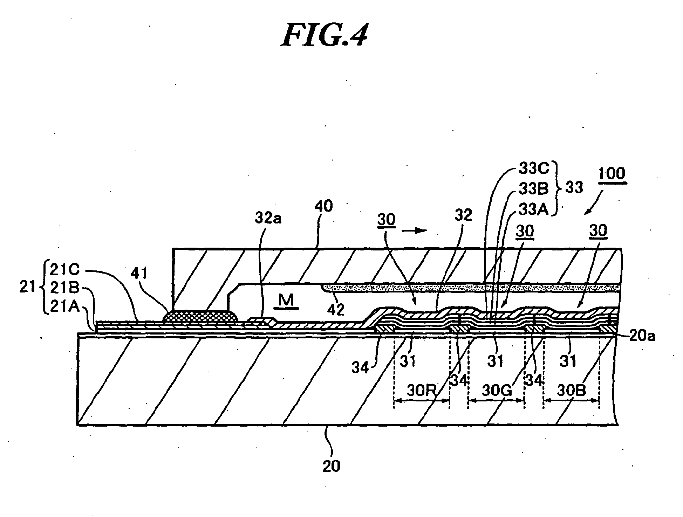

Fig. 4 is an explanatory view showing an example of an organic EL panel manufactured by the above-described manufacturing method.

As shown, the organic EL panel 100 is formed by interposing an organic layer 33 containing an organic luminescent layer between first electrodes 31 on one hand and second electrodes 32 on the other, thereby forming a plurality of organic EL devices 30 on the substrate 20. In an example shown in Fig. 4, a silicone coating layer 20a is formed on the substrate 20, and a plurality of first electrodes 31 consisting of transparent electrode material such as ITO and serving as cathodes are formed on the silicon coating layer 20a. Further, second electrodes 32 consisting of a metal and serving as anodes are formed above the first electrodes 31, thereby forming a bottom emission type panel producing light from the substrate 20 side. Moreover, the panel also contains an organic layer 33 including a hole transporting layer 33A, a luminescent layer 33B, and an electron transporting layer 33C. Then, a cover 40 is bonded to the substrate 20 through an adhesive layer 41, thereby forming a sealing space M on the substrate 20 and thus forming a display section consisting of organic EL devices 30 within the sealing space M.

In the example shown in Fig. 4, the organic EL devices 30 are formed such that the first electrodes 31 are separated by a plurality of insulating strips 34, thereby forming luminescent units (30R, 30G, 30B) under the first electrodes 31. Moreover, a desiccant layer 42 is attached to the inner surface of the cover 40, thereby preventing the organic EL devices 30 from getting deteriorated due to moisture.

Moreover, along the edge of the substrate 20 there is formed a first electrode layer 21A using the same material and the same step as forming the first electrodes 31, which is separated from the first electrodes 31 by the insulating strips 34. Further, on the lead-out portion of the first electrode layer 21A there is formed a second electrode layer 21B containing a silver-palladium (Ag-Pd) alloy and forming a low-resistant wiring portion. In addition, if necessary, a protection coating layer 21C consisting of IZO or the like is formed on the second electrode layer 21C. In this way, a lead-out electrode 21 can be formed which consists of the first electrode layer 21A, the second electrode layer 21B, and the protection coating 21C. Then, an end portion 32a of each second electrode 32 is connected to the lead-out electrode 21 within the sealing space M.

Here, although the lead-out electrode of each first electrode 31 is not shown in the drawing, it is possible to elongate each first electrode 31 and lead the same out of the sealing space M. Actually, such lead-out electrode can also be formed into an electrode layer containing Ag-Pd alloy or the like and constituting a low resistant wiring portion.

Next, description will be given to explain in detail the organic EL panel 100 and the method of manufacturing the same, according to one embodiment of the present invention.

### a. Electrodes

Either the first electrodes 31 or the second electrodes 32 are set as cathode side, while the opposite side is set as anode side. The anode side is formed by a material having a higher work function than the cathode side, using a transparent conductive film which may be a metal film such as chromium (Cr), molybdenum (Mo), nickel (Ni), and platinum (Pt), or a metal oxide film such as ITO and IZO. In contrast, the cathode side is formed by a material having a lower work function than the anode side, using a metal having a low work function, which may be an alkali metal (such as Li, Na, K, Rb, and Cs), an alkaline earth metal (such as Be, Mg, Ca, Sr, and Ba), a rare earth metal, a compound or an alloy containing two or more of the above elements, or an amorphous semiconductor such as a doped polyaniline and a doped polyphenylene vinylene, or an oxide such as Cr₂O₃, NiO, and Mn₂O₅. Moreover, when the first electrodes 31 and the second electrodes 32 are all formed by transparent materials, it is allowed to provide a reflection film on one electrode side opposite to the light emission side.

The lead-out electrodes (the lead-out electrode 14 and the lead-out electrode of the first electrodes 31) are connected with drive circuit parts driving the organic EL panel 100 or connected with a flexible wiring board. However, it is preferable for these lead-out electrodes to be formed as having a low resistance. Namely, the lead-out electrodes can be formed by laminating low resistant metal electrode layers which may be Ag-Pd alloy or APC, Cr, A1, or may be formed by single one electrode of low resistant metal.

### b. Organic layer

Although the organic layer 33 comprises one or more layers of organic compound materials including at least one organic luminescent layer, its laminated structure can be in any desired arrangement. Usually, as shown in Fig. 4, there is a laminated structure including, from the anode side towards the cathode side, a hole transporting layer 33A, a luminescent layer 33B, and an electron transporting layer 33C. Each of the hole transporting layer 33A, the luminescent layer 33B, and the electron transporting layer 33C can be in a single-layer or a multi-layered structure. Moreover, it is also possible to dispense with the hole transporting layer 33A and/or the electron transporting layer 33C. On the other hand, if necessary, it is allowed to insert other organic layers including a hole injection layer, an electron injection layer and a carrier blocking layer. Here, the hole transporting layer 33A, the luminescent layer 33B, and the electron transporting layer 33C can be formed by any conventional materials (it is allowed to use either a high molecular material or a low molecular material).

With regard to a luminescent material for forming the luminescent layer 4B, it is allowed to make use of a luminescence (fluorescence) when the material returns from a singlet excited state to a base state or a luminescence (phosphorescence) when it returns from a triplet excited state to a base state.

### c. Covering Member (Covering Film)

Further, the organic EL panel 100 according to the present invention is a panel formed by tightly covering organic EL devices 30 with a covering member 40 made of metal, glass, or plastic. Here, the covering member may be a piece of material having a recess portion (a one-step recess or a two-step recess) formed by pressing, etching, or blasting. Alternatively, the covering member may be formed by using a flat glass plate and includes an internal covering space M to be formed between the flat glass plate and the substrate by virtue of a spacer made of glass (or plastic).

In order to tightly seal the organic EL devices 30, it is also possible for the covering member 40 to be replaced by a sealing film to cover the organic EL devices 30. The covering film can be formed by laminating a single layer of protection film or a plurality of protection films, and is allowed to be formed by either an inorganic material or an organic material. Here, an inorganic material may be a nitride such as SiN, AlN, and GaN, or an oxide such as SiO, Al₂O₃, Ta₂O₅, ZnO, and GeO, or an oxidized nitride such as SiON, or a carbonized nitride such as SiCN, or a metal fluorine compound, or a metal film, etc. On the other hand, an organic material may be an epoxy resin, or an acryl resin, or a paraxylene resin, or a fluorine systemhighmolecule such as perfluoro olefin andperfluoro ether, or a metal alkoxide such as CH₃OM and C₂H₅OM, or a polyimide precursor, or a perylene system compound, etc. In practice, the above-mentioned lamination and material selection can be carried out by appropriately designing the organic EL devices.

### d. Adhesive Agent

An adhesive agent forming the adhesive layer 41 may be a thermal-setting type, a chemical-setting type (2-liquid mixture), or a light (ultraviolet) setting type, which can be formed by an acryl resin, an epoxy resin, a polyester, a polyolefine. Particularly, it is preferable to use an ultraviolet-setting epoxy resin adhesive agent which is quick to solidify without a heating treatment.

### e. Desiccating Material

Desiccating material 42 may be a physical desiccating agent such as zeolite, silica gel, carbon, and carbon nanotube; a chemical desiccating agent such as alkali metal oxide, metal halogenide, peroxide chlorine; a desiccating-agent formed by dissolving an organic metallic complex in a petroleum system solvent such as toluene, xylene, an aliphatic organic solvent and the like; and a desiccating agent formed by dispersing desiccating particles in a transparent binder such as polyethylene, polyisoprene, polyvinyl thinnate.

### f. Various Types of Organic EL Display Panels

The organic EL panel 100 of the present invention can have various types without departing from the scope of the invention. For example, the light emission type of an organic EL device 30 can be a bottom emission type emitting light from the substrate 20 side, or a top emission type emitting light from a side opposite to the substrate 20. Moreover, the EL display panel may be a single color display or a multi-color display. In practice, in order to form a multi-color display panel, it is allowed to adopt a discriminated painting method or a method in which a single color (white or blue) luminescent layer is combined with a color conversion layer formed by a color filter or a fluorescent material (CF method, CCM method), a photo breeching method which realizes a multiple light emission by emitting an electromagnetic wave or the like to the light emission area of a single color luminescent layer, or SOLED (transparent Stacked OLED) method in which two or more colors of unit display areas are laminated to form one unit display area.

According to the above-described embodiments of the present invention, at the time of supplementing film formation material to the film formation source 10 or exchanging the film formation source, since it is not necessary to break a vacuum condition or a reduced pressure condition within the film formation chamber 2, it is allowed to shorten an operation time for performing the film formation, thereby ensuring an increased efficiency for the film formation operation. Further, even if the material containers 12A, 12A₁ and 12A₂ of the film formation source 10 are changed over to different materials, film formations using different materials can still be carried out within the same film formation chamber 2.

Moreover, since there is no pressure rise within the material containers 12A, 12A₁, and 12A₂ even at the time of controlling or stopping the discharge of the film formation material from the discharge outlet 11, there would not be any trouble in the quality of the film formation material, nor any departure from the predetermined pressure range, even when the film formation material is supplemented or exchanged or when the discharge of the film formation material is shut or controlled. Further, even when the material containers 12A₁ and 12A₂ are changed over to different materials, it is still possible to continue the film formation operation without stopping or changing the film formation condition. In this way, it is possible to continuously perform, under a desired condition and for a long time period, a film formation process capable of producing a high quality film.

In this way, by virtue of the organic EL panel manufacturing process including a film formation step using various materials, it is possible to improve the productivity and thus reduce production cost. Moreover, it is possible to improve the film formation precision and thus increase product yield. Further, since the use of the film formation material collection device 16 makes it possible to increase the recovery rate of the material discharged but not used in the film formation, it is sure to reduce the production cost.

## Claims

1. A film formation apparatus (1) having a film formation chamber (2) in which a vacuum or a depressurized state is formed and a sublimated or evaporated film formation material is formed into a film on a substrate (3),
said apparatus comprising a film formation source which further comprises:
a discharge outlet (11) disposed within the film formation chamber (2) for discharging the film formation material towards a film formation surface (3A) of the substrate (3);
a material accommodating section (12) disposed outside the film formation chamber (2) and including a material container (12A) containing the film formation material; a heating device (13) for heating the film formation material contained in the material container (12A);
a discharge passage (14) disposed within the film formation chamber (2) and air-tightly communicating the discharge outlet (11) with the material accommodating section (12);
an escape passage (15) disposed within the film formation chamber (2) and branching from the discharge passage (14) for diverting the film formation material moving towards the discharge outlet (11) to a different direction; and
flow restricting devices (V1, V2) provided at least on the lower stream side of a branching position of the discharge passage (14) and on the escape passage (15), for stopping/passing or variably adjusting the flow of the film formation material,
wherein on the discharge passage and/or the escape passage there are provided a detecting port (14P, 15P) for detecting a flowing state of the film formation material, as well as a detecting device (4a, 4b) disposed within the film formation chamber (2) for detecting the film formation material discharged from the detecting port.

2. The film formation apparatus according to claim 1, wherein a film formation material collection device (16) is disposed at one end of the escape passage (15).

3. The film formation apparatus according to claim 2, wherein the film formation material collection device (16) is disposed outside the film formation chamber (2).

4. The film formation apparatus according to any one of claims 1 to 3, wherein the material accommodating section (12) includes a plurality of detachable or exchangeable material containers (12A, 12A1, 12A2), while a plurality of discharge passages (14, 141, 142) are provided in connection with the material containers (12A, 12A1, 12A2) and communicated with a common discharge outlet (11).

5. The film formation apparatus according to claim 1, 2 or 3, further comprising a control device (5) for controlling the flow restricting devices (V1, V2), which control device operates to control the flow restricting devices in accordance with detection result of the detecting device (4b).

6. A film formation method in which a discharge outlet (11) is caused to face a film formation surface (3A) of a substrate (3) disposed within a film formation chamber (2) kept at a vacuum or depressurized state, a film formation material sublimated or evaporated by heating in a material accommodating section (12) disposed outside the film formation chamber (2) is allowed to flow through a discharge passage and discharged from the discharge outlet (11) so as to form a film on the film formation surface (3A),
wherein an escape passage (15) is provided by branching from the discharge passage (14) for diverting the film formation material moving towards the discharge outlet (11) to a different direction,
wherein a flow through the escape passage (15) is started when the flow of the film formation material is shut off or restricted on the lower stream side of a branching position of the discharge passage (14),
wherein on the discharge passage and/or the escape passage there are provided a detecting port (14P, 15P) for detecting a flowing state of the film formation material as well as a detecting device (4a, 4b) disposed within the film formation chamber (2) for detecting the film formation material discharged from the detecting port,
a control device (5) for controlling the flow restricting devices (V1, V2), which control device operates to control the flow restricting devices in accordance with detection result of the detecting device (4a, 4b)

7. The film formation method according to claim 6, wherein the discharge passage (14) is kept closed and the escape passage (15) is kept open until a discharge state from the material accommodating section (12) reaches a predetermined state,
wherein after the discharge state from the material accommodating section (12) has reached a predetermined state, the discharge passage is opened and the escape passage (15) is closed.

8. The film formation method according to claim 7, wherein the material accommodating section (12) includes a plurality of detachable or exchangeable material containers (12A, 12A1, 12A2), while a plurality of discharge passages (14, 141, 142) are provided in connection with the material containers and communicated with a common discharge outlet (11),
wherein before shutting a discharge passage communicated with a first material container of the material accommodating section (12), heating is started to heat a second material container of the material accommodating section (12),
wherein a discharge passage communicated with a second material container is kept closed and an escape passage branching from the discharge passage is kept open until a discharge state from the second material container reaches a predetermined state,
wherein after the discharge state from the second material container has reached a predetermined state, the discharge passage communicated with the second material container is opened and the escape passage branching from the discharge passage is closed.

9. The film formation method according to claim 8, wherein after the discharge passage communicated with the second material container is opened, the escape passage branching from the discharge passage communicated with the first material container is also opened, and the discharge passage communicated with the first material container is closed.

10. The film formation method according to any one of claims 6 to 9, wherein the discharge outlet (11) and the film formation surface (3A) of the substrate (3) are caused not to face each other, and the discharge through the escape passage communicated with the first material container is changed over to the discharge through the discharge passage communicated with the second material container.

11. The film formation method according to anyone of claims 6 to 10, wherein a film formation material collection device (16) is disposed at the end of the escape passages (15, 151, 152) to collect the film formation material passing through the escape passages (15, 151, 152).

12. A method of manufacturing an organic EL panel (100) comprising a substrate (20) and at least one organic EL device (30) formed on the substrate (20), said at least one organic EL device (30) including a first electrode (31), a second electrode (32), and an organic material layer (33) interposed between the first and second electrodes, said organic material layer (33) containing an organic luminescent layer,
wherein at least one kind of film formation material for forming the first electrode (31), the second electrode (32) or the organic material layer (33) is formed into a film on the substrate (20), using a film formation apparatus according to any one of claims 1-5 or a film formation method according to any one of claims 6 to 10.

## Patentansprüche

1. Filmbildungsvorrichtung (1) mit einer Filmbildungskammer (2), in der ein Vakuum oder ein druckloser Zustand hergestellt und ein sublimiertes oder verdampftes Filmbildungsmaterial zu einem Film auf einem Substrat (3) ausgebildet wird,
wobei die Vorrichtung eine Filmbildungsquelle umfasst, die darüber hinaus umfasst:
eine Ausleitungsöffnung (11), die innerhalb der Filmbildungskammer (2) angeordnet ist, um das Filmbildungsmaterial zu einer Filmbildungsfläche (3A) des Substrats (3) auszuleiten;
einen Materialunterbringungsabschnitt (12), der außerhalb der Filmbildungskammer (2) angeordnet ist und einen Materialbehälter (12A) umfasst, der das Filmbildungsmaterial enthält; eine Heizvorrichtung (13), um das im Materialbehälter (12A) enthaltene Filmbildungsmaterial zu erwärmen;
einen Ausleitungskanal (14), der innerhalb der Filmbildungskammer (2) angeordnet ist und die Ausleitungsöffnung (11) luftdicht mit dem Materialunterbringungsabschnitt (12) in Verbindung setzt;
einen Entweichkanal (15), der innerhalb der Filmbildungskammer (2) vorgesehen ist und vom Ausleitungskanal (14) abzweigt, um das Filmbildungsmaterial, das sich zur Ausleitungsöffnung (11) bewegt, in eine andere Richtung umzuleiten; und
Strömungsdrosselungsvorrichtungen (V1, V2), die zumindest auf der unteren Strömungsseite einer Abzweigungsstelle des Ausleitungskanals (14) und im Entweichkanal (15) vorgesehen sind, um die Strömung des Filmbildungsmaterials anzuhalten/durchzulassen oder variabel einzustellen,
wobei im Ausleitungskanal und/oder Entweichkanal eine Erfassungsöffnung (14P, 15P), um einen Fließzustand des Filmbildungsmaterials zu erfassen, sowie eine innerhalb der Filmbildungskammer (2) angeordnete Erfassungsvorrichtung (4a, 4b) vorgesehen sind, um das aus der Erfassungsöffnung ausgeleitete Filmbildungsmaterial zu erfassen.

2. Filmbildungsvorrichtung nach Anspruch 1, wobei eine Filmbildungsmaterialauffangeinrichtung (16) an einem Ende des Entweichkanals (15) angeordnet ist.

3. Filmbildungsvorrichtung nach Anspruch 2, wobei die Filmbildungsmaterialauffangeinrichtung (16) außerhalb der Filmbildungsmaterialkammer (2) angeordnet ist.

4. Filmbildungsvorrichtung nach einem der Ansprüche 1 bis 3, wobei der Materialunterbringungsabschnitt (12) mehrere abnehmbare oder austauschbare Materialbehälter (12A, 12A1, 12A2) umfasst, während mehrere Ausleitungskanäle (14, 141, 142) in Verbindung mit den Materialbehältern (12A, 12A1, 12A2) vorgesehen und mit einer gemeinsamen Ausleitungsöffnung (11) in Verbindung gesetzt sind.

5. Filmbildungsvorrichtung nach Anspruch 1, 2 oder 3, darüber hinaus eine Steuervorrichtung (5) umfassend, um die Strömungsdrosselungsvorrichtungen (V1, V2) zu steuern, welche Steuervorrichtung so arbeitet, dass die Strömungsdrosselungsvorrichtungen entsprechend dem Erfassungsergebnis der Erfassungsvorrichtung (4b) gesteuert werden.

6. Filmbildungsverfahren, bei dem eine Auslassöffnung (11) dazu gebracht wird, einer Filmbildungsfläche (3A) eines innerhalb einer auf einem Vakuum oder drucklosen Zustand gehaltenen Filmbildungskammer (2) angeordneten Substrats (3) zugewandt zu sein, ein Filmbildungsmaterial, das durch Erwärmen in einem außerhalb der Filmbildungskammer (2) angeordneten Materialunterbringungsabschnitt (12) sublimiert oder verdampft wird, durch einen Ausleitungskanal fließen gelassen und aus der Ausleitungsöffnung (11) ausgeleitet wird, um einen Film auf der Filmbildungsfläche (3A) zu bilden,
wobei ein Entweichkanal (15) durch Abzweigung vom Ausleitungskanal (14) vorgesehen ist, um das Filmbildungsmaterial, das sich zur Ausleitungsöffnung (11) bewegt, in eine andere Richtung umzuleiten;
wobei eine Strömung durch den Entweichkanal (15) dann beginnt, wenn die Strömung des Filmbildungsmaterials auf der unteren Strömungsseite einer Abzweigungsstelle des Ausleitungskanals (14) abgesperrt oder gedrosselt ist,
wobei im Ausleitungskanal und/oder Entweichkanal eine Erfassungsöffnung (14P, 15P), um einen Fließzustand des Filmbildungsmaterials zu erfassen, sowie eine innerhalb der Filmbildungskammer (2) angeordnete Erfassungsvorrichtung (4a, 4b) vorgesehen sind, um das aus der Erfassungsöffnung ausgeleitete Filmbildungsmaterial zu erfassen,
wobei eine Steuervorrichtung (5), um die Strömungsdrosselungsvorrichtungen (V1, V2) zu steuern, so arbeitet, dass die Strömungsdrosselungsvorrichtungen entsprechend dem Erfassungsergebnis der Erfassungsvorrichtung (4a, 4b) gesteuert werden.

7. Filmbildungsverfahren nach Anspruch 6, wobei der Ausleitungskanal (14) geschlossen und der Entweichkanal (15) offen gehalten wird, bis ein Ausleitungszustand aus dem Materialunterbringungsabschnitt (12) einen vorbestimmten Zustand erreicht,
wobei, nachdem der Ausleitungszustand aus dem Materialunterbringungsabschnitt (12) einen vorbestimmten Zustand erreicht hat, der Ausleitungskanal geöffnet und der Entweichkanal (15) geschlossen wird.

8. Filmbildungsverfahren nach Anspruch 7, wobei der Materialunterbringungsabschnitt (12) mehrere abnehmbare oder austauschbare Materialbehälter (12A, 12A1, 12A2) umfasst, während mehrere Ausleitungskanäle (14, 141, 142) in Verbindung mit den Materialbehältern vorgesehen und mit einer gemeinsamen Ausleitungsöffnung (11) in Verbindung gesetzt sind,
wobei, bevor ein mit einem ersten Materialbehälter des Materialunterbringungsabschnitts (12) in Verbindung gesetzter Ausleitungskanal abgesperrt wird, ein Erwärmen beginnt, um einen zweiten Materialbehälter des Materialunterbringungsabschnitts (12) zu erwärmen,
wobei ein mit einem zweiten Materialbehälter in Verbindung gesetzter Ausleitungskanal geschlossen gehalten und ein von dem Ausleitungskanal abzweigender Entweichkanal offen gehalten wird, bis ein Ausleitungszustand aus dem zweiten Materialbehälter einen vorbestimmten Zustand erreicht,
wobei, nachdem der Ausleitungszustand aus dem zweiten Materialbehälter einen vorbestimmten Zustand erreicht hat, der mit dem zweiten Materialbehälter in Verbindung gesetzte Ausleitungskanal geöffnet und der von dem Ausleitungskanal abzweigende Entweichkanal geschlossen wird.

9. Filmbildungsverfahren nach Anspruch 8, wobei, nachdem der mit dem zweiten Materialbehälter in Verbindung gesetzte Ausleitungskanal geöffnet wurde, auch der Entweichkanal geöffnet wird, der von dem mit dem ersten Materialbehälter in Verbindung gesetzten Ausleitungskanal abzweigt, und der mit dem ersten Materialbehälter in Verbindung gesetzte Ausleitungskanal geschlossen wird.

10. Filmbildungsverfahren nach einem der Ansprüche 6 bis 9, wobei die Ausleitungsöffnung (11) und die Filmbildungsfläche (3A) des Substrats (3) dazu gebracht werden, einander nicht zugewandt zu sein, und die Ausleitung durch den mit dem ersten Materialbehälter in Verbindung gesetzten Entweichkanal auf die Ausleitung durch den mit dem zweiten Materialbehälter in Verbindung gesetzten Ausleitungskanal umgestellt wird.

11. Filmbildungsverfahren nach einem der Ansprüche 6 bis 10, wobei eine Filmbildungsmaterialauffangeinrichtung (16) am Ende der Entweichkanäle (15, 151, 152) angeordnet ist, um das Filmbildungsmaterial aufzufangen, das durch die Ausweichkanäle (15, 151, 152) hindurchtritt.

12. Verfahren zur Herstellung eines organischen EL-Panels (100) mit einem Substrat (20) und mindestens einer auf dem Substrat (20) ausgebildeten EL-Vorrichtung (30), wobei die mindestens eine organische EL-Vorrichtung (30) eine erste Elektrode (31), eine zweite Elektrode (32) und eine organische Materialschicht (33) umfasst, die zwischen der ersten und zweiten Elektrode eingesetzt ist, wobei die organische Materialschicht (33) eine organische Lumineszenzschicht enthält,
wobei mindestens eine Art Filmbildungsmaterial zum Ausbilden der ersten Elektrode (31), der zweiten Elektrode (32) oder der organischen Materialschicht (33) zu einem Film auf dem Substrat (20) ausgebildet ist, und zwar unter Verwendung einer Filmbildungsvorrichtung nach einem der Ansprüche 1 bis 5 oder einem Filmbildungsverfahren nach einem der Ansprüche 6 bis 10.

## Revendications

1. Dispositif de formation de film (1) ayant une chambre de formation de film (2) dans laquelle un état de vide ou un état sans pression est formé et une matière de formation de film sublimée ou évaporée est formée dans un film sur un substrat (3),
ledit dispositif comportant une source de formation de film qui comporte en outre :
une sortie d'évacuation (11) disposée à l'intérieur de la chambre de formation de film (2) pour évacuer la matière de formation de film en direction d'une surface de formation de film (3A) du substrat (3),
une partie réceptrice de matière (12) disposée à l'extérieur de la chambre de formation de film (2) et incluant un conteneur de matière (12A) contenant la matière de formation de film,
un dispositif de chauffage (13) pour chauffer la matière de formation de film contenue dans le conteneur de matière (12A),
un passage d'évacuation (14) disposé à l'intérieur de la chambre de formation de film (2) et faisant communiquer de manière étanche à l'air la sortie d'évacuation (11) et la partie réceptrice de matière (12),
un passage d'échappement (15) disposé à l'intérieur de la chambre de formation de film (2) et bifurquant à partir du passage d'évacuation (14) pour dévier la matière de formation de film se déplaçant vers la sortie de décharge (11) dans une direction différente, et
des dispositifs de restriction d'écoulement (V1, V2) agencés au moins sur le côté aval d'une position de bifurcation du passage d'évacuation (14) et sur le passage d'échappement (15), pour arrêter/laisser passer ou régler de manière variable l'écoulement de la matière de formation de film,
dans lequel, sur le passage d'évacuation et/ou le passage d'échappement sont agencés un orifice de détection (14P, 15P) pour détecter un état d'écoulement de la matière de formation de film, ainsi qu'un dispositif de détection (4a, 4b) disposé à l'intérieur de la chambre de formation de film (2) pour détecter la matière de formation de film évacuée à partir de l'orifice de détection.

2. Dispositif de formation de film selon la revendication 1, dans lequel un dispositif de collecte de matière de formation de film (16) est disposé à une extrémité du passage d'échappement (15).

3. Dispositif de formation de film selon la revendication 2, dans lequel le dispositif de collecte de matière de formation de film (16) est disposé à l'extérieur de la chambre de formation de film (2).

4. Dispositif de formation de film selon l'une quelconque des revendications 1 à 3, dans lequel la partie réceptrice de matière (12) inclut une pluralité de conteneurs de matière amovibles ou échangeables (12A, 12A₁, 12A₂), alors qu'une pluralité de passages d'évacuation (14, 14₁,14₂) est agencée en liaison avec les conteneurs de matière (12A, 12A₁, 12A₂) et en communication avec une sortie d'évacuation commune (11).

5. Dispositif de formation de film selon la revendication 1, 2 ou 3, comportant également un dispositif de commande (5) pour commander les dispositifs de restriction d'écoulement (V1, V2), lequel dispositif de commande fonctionne pour commander les dispositifs de restriction d'écoulement en fonction d'un résultat de détection du dispositif de détection (4b).

6. Procédé de formation de film dans lequel une sortie d'évacuation (11) est amenée en vis-à-vis d'une surface de formation de film (3A) d'un substrat (3) disposé à l'intérieur d'une chambre de formation de film (2) maintenue à un état de vide ou sans pression, une matière de formation de film sublimée ou évaporée par chauffage dans une partie réceptrice de matière (12) disposée à l'extérieur de la chambre de formation de film (2) peut s'écouler à travers un passage d'évacuation et être évacuée par la sortie d'évacuation (11) de manière à former un film sur la surface de formation de film (3A),
dans lequel un passage d'échappement (15) est créé par une bifurcation à partir du passage d'évacuation (14) pour dévier la matière de formation de film se déplaçant vers la sortie d'évacuation (11) dans une direction différente,
dans lequel un écoulement à travers le passage d'échappement (15) est débuté lorsque l'écoulement de la matière de formation de film est arrêté ou restreint sur le côté aval d'une position de bifurcation du passage d'évacuation (14),
dans lequel, sur le passage d'évacuation et/ou le passage d'échappement, sont agencés un orifice de détection (14P, 15P) pour détecter un état d'écoulement de la matière de formation de film, ainsi qu'un dispositif de détection (4a, 4b) disposé à l'intérieur de la chambre de formation de film (2) pour détecter la matière de formation de film évacuée depuis l'orifice de détection,
un dispositif de commande (5) pour commander les dispositifs de restriction d'écoulement (V1, V2), lequel dispositif de commande fonctionne pour commander les dispositifs de restriction d'écoulement en fonction d'un résultat de détection du dispositif de détection (4a, 4b).

7. Procédé de formation de film selon la revendication 6, dans lequel le passage d'évacuation (14) est maintenu fermé et le passage d'échappement (15) est maintenu ouvert jusqu'à ce qu'un état d'évacuation depuis la partie réceptrice de matière (12) atteigne un état prédéterminé,
dans lequel, après que l'état d'évacuation depuis la partie réceptrice de matière (12) ait atteint un état prédéterminé, le passage d'évacuation est ouvert et le passage d'échappement (15) est fermé.

8. Procédé de formation de film selon la revendication 7, dans lequel la partie réceptrice de matière (12) inclut une pluralité de conteneurs de matière amovibles ou échangeables (12A, 12A₁, 12A₂), alors qu'une pluralité de passages d'évacuation (14, 14₁,14₂) est agencée en liaison avec les conteneurs de matière et en communication avec une sortie d'évacuation commune (11),
dans lequel, avant de fermer un passage d'évacuation mis en communication avec un premier conteneur de matière de la partie réceptrice de matière (12), un chauffage est démarré pour chauffer un second conteneur de matière de la partie réceptrice de matière (12),
dans lequel un passage d'évacuation mis en communication avec un second conteneur de matière est maintenu fermé et un passage d'échappement bifurquant à partir du passage d'évacuation est maintenu ouvert jusqu'à ce qu'un état d'évacuation depuis le second conteneur de matière atteigne un état prédéterminé,
dans lequel, après que l'état d'évacuation depuis le second conteneur de matière ait atteint un état prédéterminé, le passage d'évacuation mis en communication avec le second conteneur de matière est ouvert et le passage d'échappement bifurquant à partir du passage d'évacuation est fermé.

9. Procédé de formation de film selon la revendication 8, dans lequel, après que le passage d'évacuation mis en communication avec le second conteneur de matière ait été ouvert, le passage d'échappement bifurquant à partir du passage d'évacuation mis en communication avec le premier conteneur de matière est également ouvert, et le passage d'évacuation mis en communication avec le premier conteneur de matière est fermé.

10. Procédé de formation de film selon l'une quelconque des revendications 6 à 9, dans lequel la sortie d'évacuation (11) et la surface de formation de film (3A) du substrat (3) ne sont pas amenées l'une en face de l'autre, et l'évacuation à travers le passage d'échappement mis en communication avec le premier conteneur de matière est basculée sur l'évacuation à travers le passage d'évacuation mis en communication avec le second conteneur de matière.

11. Procédé de formation de film selon l'une quelconque des revendications 6 à 10, dans lequel un dispositif de collecte de matière de formation de film (16) est disposé à l'extrémité des passages d'échappement (15, 15₁,15₂) pour collecter la matière de formation de film passant à travers les passages d'échappement (15, 15₁,15₂).

12. Procédé de fabrication d'un panneau EL organique (100) comportant un substrat (20) et au moins un dispositif EL organique (30) formé sur le substrat (20), ledit au moins un dispositif EL organique (30) incluant une première électrode (31), une seconde électrode (32) et une couche de matière organique (33) intercalée entre les première et seconde électrodes, ladite couche de matière organique (33) contenant une couche luminescente organique,
dans lequel au moins un type de matière de formation de film pour former la première électrode (31), la seconde électrode (32) ou la couche de matière organique (33) est formé dans un film sur le substrat (20), en utilisant un dispositif de formation de film selon l'une quelconque des revendications 1 à 5 ou un procédé de formation de film selon l'une quelconque des revendications 6 à 10.
